# EUROPEAN PATENT APPLICATION

(11) **EP 2 704 316 A2**
(43) Date of publication of application: **05.03.2014**
(21) Application number: 13169959.7
(22) Date of filing: 31.05.2013
(51) Int. Cl.: H03F 1/02, H03F 1/56, H03F 3/189

(54) **Power amplification device**

(30) Priority: 27.08.2012 JP 2012186882
(71) Applicant: FUJITSU LIMITED, Kawasaki-shi, Kanagawa 211-8588 (JP)
(72) Inventor: Takano, Takeshi, Kawasaki-shi, Kanagawa 211-8588 (JP); Kojima, Masakazu, Kawasaki-shi, Kanagawa 211-8588 (JP); Nakamura, Michiharu, Kawasaki-shi, Kanagawa 211-8588 (JP); Maniwa, Toru, Kawasaki-shi, Kanagawa 211-8588 (JP); Kimura, Shigekazu, Kawasaki-shi, Kanagawa 211-8588 (JP); Tamanoi, Ken, Kawasaki-shi, Kanagawa 211-8588 (JP)
(74) Representative: Fenlon, Christine Lesley

(57) **Abstract**

A power amplification device, includes: an amplifier to amplify an input signal; a switched capacitor, provided at an output stage of the amplifier, to change capacitance based on a first control signal; a matching unit, provided at the output stage of the amplifier and including a varactor pair in which two varactor diodes are coupled in series or a varactor pair in which two varactor diodes are coupled in parallel, to change capacitance based on a second control signal; a detection circuit to detect power of the input signal; a quantization circuit to quantize a detected power value, form a quantized bit string having a high-order bit group and a low-order bit group, and output the high-order bit group as the first control signal to the switched capacitor; and a conversion circuit to convert the low-order bit group into an analog value and form the second control signal.

## Description

### FIELD

The embodiments discussed herein are related to a power amplification device.

### BACKGROUND

Much of the power in a base station or a terminal is consumed by a power amplifier. Therefore, to reduce power consumption in a base station or a terminal, the efficiency of the power amplifier is increased.

When a power amplifier is excited by a sinusoidal wave, efficiency is highest at the maximum power value, for example, at the maximum amplitude value. However, efficiency may decrease as the power level decreases from the maximum power value. The amplitude of a transmission signal that is input to the power amplifier and amplified may not be fixed. Therefore, when the transmission signal is amplified, the efficiency of the power amplifier may, on average, decrease from the highest efficiency. Therefore, in order to minimize the decrease in the average power efficiency, for example, a power efficiency that is close to the highest value may be ensured also when the amplitude is low.

An increase in efficiency is achieved together with a decrease in distortion by controlling load impedance in a power amplifier. In a power amplifier, the load impedance with which the maximum power is obtained and the load impedance with which the maximum efficiency is obtained are different. Therefore, when the load impedance with which the maximum power is obtained is set, it may not be possible to obtain the highest efficiency. When the load impedance with which the highest efficiency is obtained is set, it may not be possible to obtain the maximum output power. Therefore, when load impedance is changed in accordance with the amplitude of a signal, the average power efficiency may increase as a result of switching between the load impedance with which the maximum power is obtained and the load impedance with which the highest efficiency is obtained.

The bandwidth of an envelope signal is estimated as being approximately ten times the bandwidth of a baseband signal. For example, the bandwidth of four carriers according to the 3rd Generation Partnership Project (3GPP) system, for example W-CDMA, is 20 MHz, and the bandwidth of a baseband signal is 10 MHz. The bandwidth of an envelope signal is approximately 100 MHz. Therefore, a matching circuit for load impedance adjustment that operates at high speed is provided so that load impedance is made to track the envelope (tracking). A mechanical variable-capacitance capacitor having an operating speed of the order of several hertz and a microelectromechanical system (MEMS) having an operating speed of the order of several megahertz might not be used in the matching circuit.

The high-speed matching circuit may include the two types of a digital type and an analog type.

A digital type of matching circuit includes, for example, a semiconductor switch and a plurality of capacitors that are coupled in parallel to the semiconductor switch and have different fixed capacitances. The digital type of matching circuit changes an additional impedance value by switching the set of coupled capacitors. On the other hand, an analog type of matching circuit includes a varactor diode or a transistor-equipped variable capacitance element that is equivalent to a varactor diode.

Related technology is disclosed in Japanese Laid-open Patent Publication No. 2008-118624.

The digital type of matching circuit operates at high speed because switches are controlled by directly applying an envelope signal, but the digital type of matching circuit may not be able to ensure the precision of capacitors having a low fixed capacitance, and resolution may decrease.

The analog type of matching circuit operates at high speed, but may also respond to a radio frequency (RF) signal the tracking of which is not desired. The spectrum therefore expands, and distortion may increase. When distortion is compensated using a complex distortion compensation circuit, power consumption may increase.

### SUMMARY

According to an embodiment of an aspect, a power amplification device, includes: an amplifier configured to amplify an input signal; a switched capacitor, provided at an output stage of the amplifier, configured to change capacitance based on a first control signal; a matching unit, provided at the output stage of the amplifier and including a varactor pair in which two varactor diodes are coupled in series and in opposing directions or a varactor pair in which two varactor diodes are coupled in parallel and in opposing directions, configured to change capacitance based on a second control signal; a detection circuit configured to detect power of the input signal; a quantization circuit to quantize a detected power value, form a quantized bit string having a high-order bit group and a low-order bit group, and output the high-order bit group as the first control signal to the switched capacitor; and a conversion circuit to convert the low-order bit group into an analog value and form the second control signal.

High-speed operation may become possible, the resolution of additional impedance may improve and responses to RF signals may decrease.

The advantages of the invention will be realized and attained by means of the elements and combinations particularly pointed out in the claims.

It is to be understood that both the foregoing general description and the following detailed description are exemplary and explanatory and are not restrictive of the invention, as claimed.

### BRIEF DESCRIPTION OF DRAWINGS

FIG. 1 depicts an example of a power amplification device;

FIG. 2 depicts an example of a control unit;

FIG. 3 depicts an example of a matching circuit;

FIG. 4 depicts an example of a matching circuit;

FIG. 5 depicts an example of a matching unit;

FIG. 6 depicts an example of a matching unit;

FIG. 7 depicts an example of a matching unit;

FIG. 8 depicts an example of a matching unit; and

FIG. 9 depicts an example of a base station.

### DESCRIPTION OF EMBODIMENTS

In the drawings, components having the same or similar function are appended with the same symbol, and the descriptions thereof may be omitted.

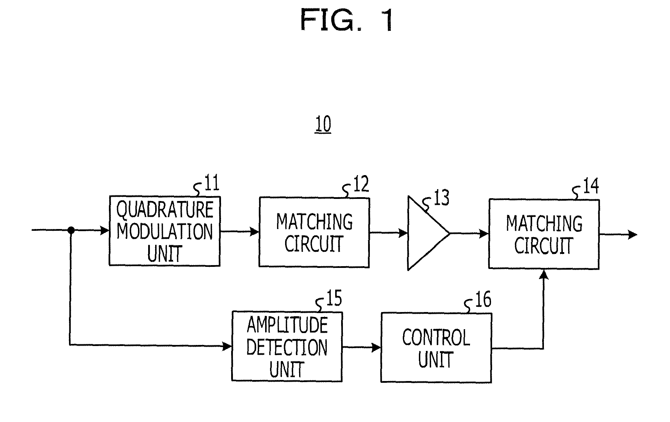

FIG. 1 depicts an example of a power amplification device. A power amplification device 10 includes a quadrature modulation unit 11, matching circuits 12 and 14, an amplifier 13, an amplitude detection unit 15, and a control unit 16. The quadrature modulation unit 11, the matching circuits 12 and 14, and the amplifier 13 may be provided on a main transmission line through which a transmission signal is transmitted.

The amplitude detection unit 15 detects the amplitude, for example power, of the transmission signal, and outputs the value of the detected amplitude to the control unit 16. The amplitude detection unit 15 detects the amplitude of the transmission signal at certain detection intervals. The detected transmission signal amplitude may be, for example, the average power within the detection intervals, or may be the peak power within the detection intervals.

The control unit 16 quantizes the amplitude values detected in the amplitude detection unit 15, and thereby generates a quantized bit string of N number of quantized bits (N being a natural number of 2 or more). The quantized bit string is divided into a high-order bit group and a low-order bit group. The high-order bit group is output to the matching circuit 14, and the low-order bit group is converted from a digital value to an analog value and the analog value corresponding to the low-order bit group is output to the matching circuit 14. The high-order bits may correspond to a large step width, and the low-order bits may correspond to a small step width.

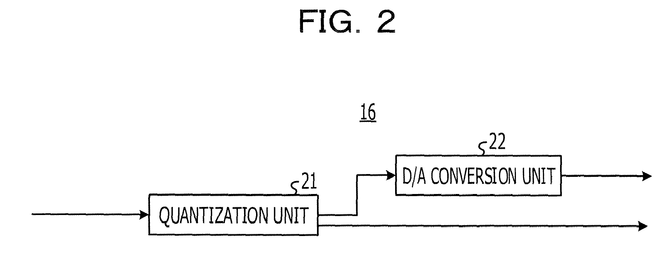

FIG. 2 depicts an example of a control unit. The control unit depicted in FIG. 2 may be the control unit 16 depicted in FIG. 1. In FIG. 2, the control unit 16 has a quantization unit 21 and a D/A conversion unit 22. The quantized bit string is formed by processing in the quantization unit 21. The D/A conversion of the low-order bit group is performed by the D/A conversion unit 22.

The quadrature modulation unit 11 subjects the transmission signal to quadrature modulation and outputs the quadrature-modulated transmission signal to the matching circuit 12. Up-conversion processing is performed in the quadrature modulation unit 11.

The matching circuit 12 is provided at the input stage of the amplifier 13, and matches the impedance at the input side of the amplifier 13.

The amplifier 13 amplifies the input transmission signal while altering saturation power in accordance with the magnitude of the power source voltage, and outputs the amplified transmission signal to the matching circuit 14.

The matching circuit 14 is provided at the output stage of the amplifier 13, and matches the impedance at the output side of the amplifier 13, based on the quantized bit string formed by the control unit 16.

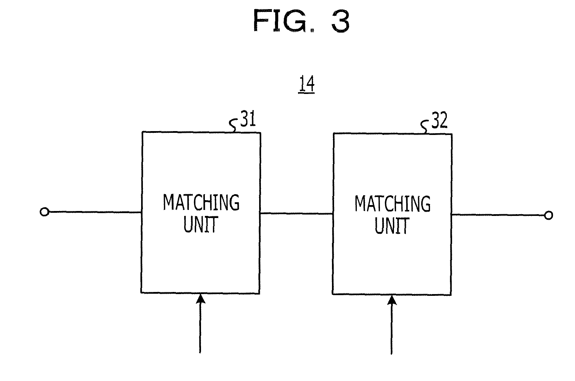

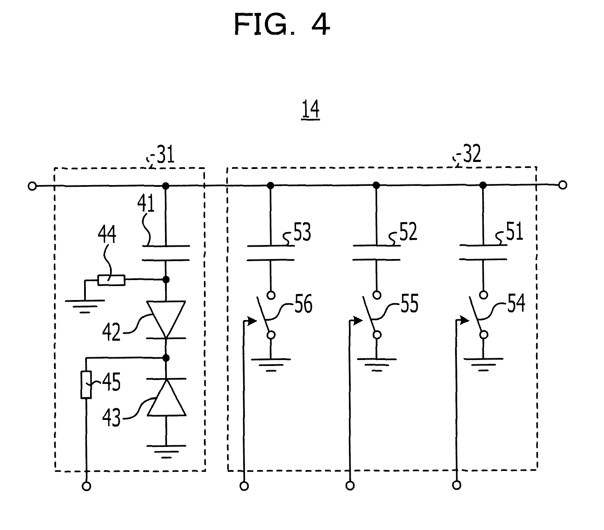

FIG. 3 and FIG. 4 depict an example of a matching circuit. The matching circuit depicted in FIG. 3 may be the matching circuit 14 depicted in FIG. 1. The matching circuit 14 depicted in FIG. 3 has matching units 31 and 32.

The matching unit 31 changes capacitance in accordance with an analog value obtained by the D/A conversion unit 22. For example, as depicted in FIG. 4, the matching unit 31 includes, between the main transmission line and ground, a pair of varactor diodes such as an anti-series varactor pair that are coupled in series and in opposing directions.

As depicted in FIG. 4, the matching unit 31 includes a capacitor 41, varactors 42 and 43, and resistances 44 and 45. One end of the capacitor 41 is coupled to the main transmission line, and the other end is coupled to the anode of the varactor 42. Ground and the coupling point of the capacitor 41 and the varactor 42 are coupled via the resistance 44. The cathode of the varactor 43 is coupled to the cathode of the varactor 42. The anode of the varactor 43 is coupled to ground. An analog-value input terminal and the coupling point of the varactor 42 and the varactor 43 are coupled via the resistance 45.

An analog value such as an analog voltage signal is applied to the coupling point of the varactor 42 and the varactor 43, and a capacitance value thereby changes in accordance with the analog value. The magnitude of the load impedance therefore changes. The capacitances of the varactors 42 and 43 may be equal to or less than the capacitance of the capacitor having the lowest capacitance from among the capacitors included in the matching unit 32.

The matching unit 32 changes capacitance, based on the high-order bit group obtained by the control unit 16. For example, as depicted in FIG. 4, the matching unit 32 includes capacitors 51 to 53 having mutually different capacitance, and switches 54 to 56. The matching unit 32 may be a switched capacitor, for example. One end of the capacitor 51 is coupled to the main transmission line, and the other end thereof is coupled to ground via the switch 54. Likewise, one end of the capacitor 52 is coupled to the main transmission line, and the other end thereof is coupled to ground via the switch 55. One end of the capacitor 53 is coupled to the main transmission line, and the other end thereof is coupled to ground via the switch 56.

The high-order bit group may be, for example, three bits. The most significant bit within the high-order bit group may correspond to the capacitor 51 having the highest capacitance and the switch 54. The second most significant bit may correspond to the capacitor 52 having the second highest capacitance and the switch 55. The third most significant bit may correspond to the capacitor 53 having the third highest capacitance and the switch 56. The capacitance of the capacitor 51 may be, for example, 4 picofarads (pF). The capacitance of the capacitor 52 may be, for example, 2 pF which is half the capacitance of the capacitor 51. The capacitance of the capacitor 53 may be, for example, 1 pF which is a quarter of the capacitance of the capacitor 51. A switch corresponding to a bit having a bit value of 1 in the high-order bit group is set to ON, and the corresponding capacitor is thereby coupled to ground. Because the capacitance value changes in accordance with the high-order bit group which constitutes a digital value, the magnitude of the load impedance changes.

In the power amplification device 10, the control unit 16 quantizes detected amplitude values and forms a quantized bit string. The D/A conversion unit 22 subjects the low-order bit group of the formed quantized bit string to D/A conversion and forms an analog voltage signal. The matching unit 31, which includes the anti-series varactor pair, changes capacitance in accordance with the analog voltage signal obtained by the D/A conversion unit 22. The matching unit 32 changes capacitance, based on the high-order bit group obtained by the control unit 16.

By combining an analog type and a digital type of matching circuit, high-speed operation may become possible and the resolution of additional impedance may improve. Capacitance is controlled in the matching unit 31 based on the low-order bit group rather than the high-order bit group, and the amount of change in the capacitance of the matching unit 31 may decrease. As a result, the change in capacitance may have linear characteristics. The matching unit 31 includes the anti-series varactor pair and therefore, in a state in which the change in capacitance has linear characteristics, change in capacitance caused by an RF signal may be canceled. For example, responses to RF signals may decrease.

The high-order bit group may be three bits. An M number of constituent bits of the high-order bit group may be a natural number that is less than N and is equal to or greater than 2. The matching unit 32 may have M number of capacitors that are coupled in parallel and have different capacitances.

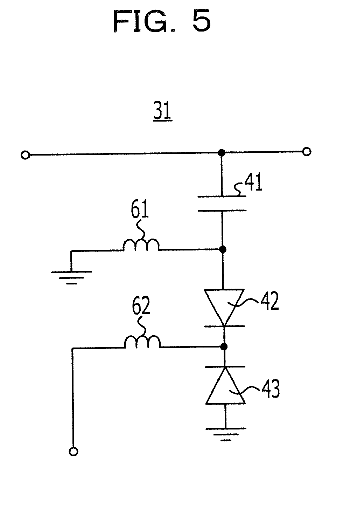

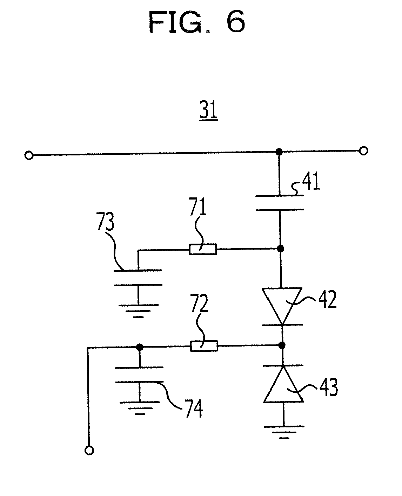

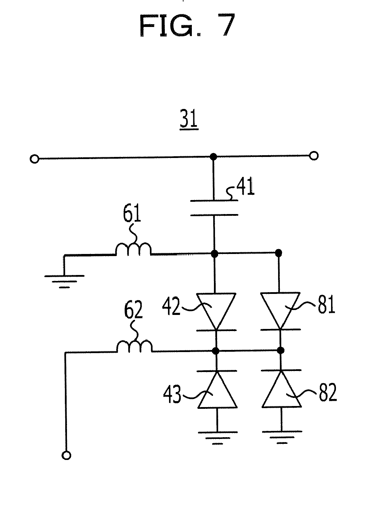

FIG. 5 to FIG. 7 depict an example of a matching unit. As depicted in FIG. 5, in the matching unit 31, coils 61 and 62 may be provided instead of the resistances 44 and 45. As depicted in FIG. 6, in the matching unit 31, λ/4 lines 71 and 72 and capacitors 73 and 74 may be used instead of the resistances 44 and 45. The number of anti-series varactor pairs included in the matching unit 31 is not limited to one pair, and as depicted in FIG. 7, a plurality of parallel-coupledd anti-series varactor pairs may be included. For example, in FIG. 7, an anti-series varactor pair of varactors 81 and 82 is provided.

A connection line, such as a driver line, that couples the control unit 16 and the matching unit 32, a connection line that couples the control unit 16 and the D/A conversion unit 22, and a connection line that couples the D/A conversion unit 22 and the matching unit 31 are compatible with a wide bandwidth. The connection lines may include, for example, a stripline.

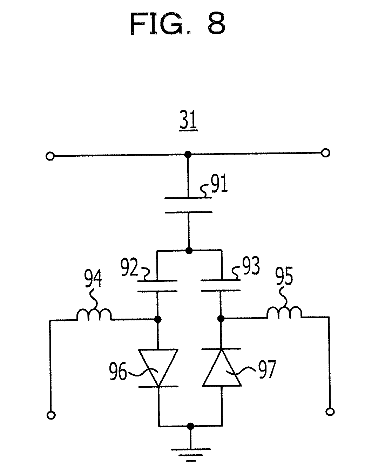

FIG. 8 depicts an example of a matching unit. In FIG. 8, the matching unit 31 includes, between the main transmission line and ground, a pair of varactor diodes, namely an anti-parallel varactor pair, that are coupled in parallel and in opposing directions.

In FIG. 8, a matching unit that is controlled by an analog voltage signal is depicted. An anti-parallel varactor pair may be used instead of an anti-series varactor pair.

For example, the matching unit 31 has capacitors 91 to 93, coils 94 and 95, and varactors 96 and 97. One end of the capacitor 91 is coupled to the main transmission line, and the other end is coupled in parallel to one end of the capacitor 92 and one end of the capacitor 93. The other end of the capacitor 92 is coupled to the anode of the varactor 96. An analog-value first input terminal and the coupling point of the capacitor 92 and the varactor 96 are coupled via the coil 94. The other end of the capacitor 93 is coupled to the cathode of the varactor 97. An analog-value second input terminal and the coupling point of the capacitor 93 and the varactor 97 are coupled via the coil 95. The cathode of the varactor 96 and the anode of the varactor 97 are coupled to ground.

An analog value such as an analog voltage signal is applied to the coupling point of the capacitor 92 and the varactor 96, and to the coupling point of the capacitor 93 and the varactor 97, and a capacitance value is thereby changed in accordance with the analog value. The magnitude of the load impedance therefore changes. The analog value that is input to the first input terminal and the analog value that is input to the second input terminal may have opposite signs. The capacitances of the varactors 96 and 97 may be equal to or less than the capacitance of the capacitor having the lowest capacitance from among the capacitors included in the matching unit 32.

When the matching unit 31 includes an anti-parallel varactor pair instead of an anti-series varactor pair, the same effect as described above may be obtained.

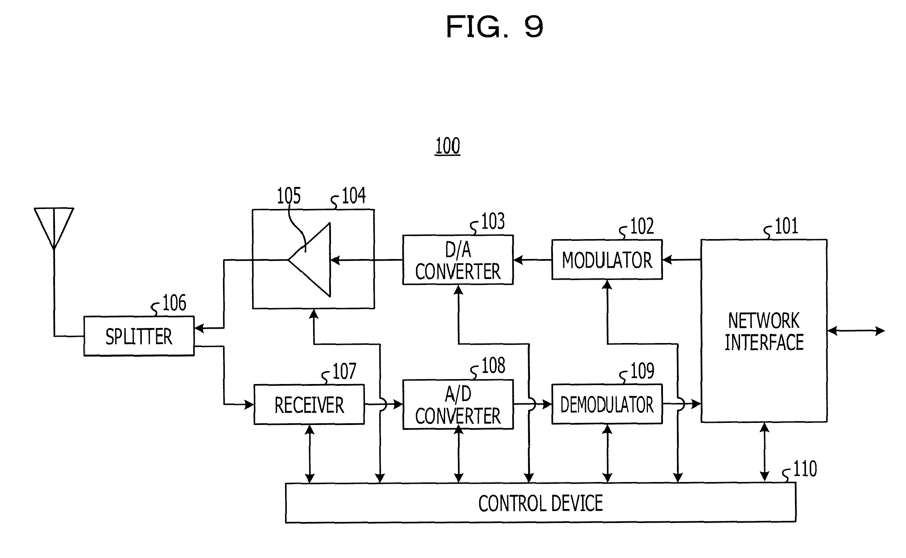

FIG. 9 depicts an example of a base station.

A base station 100 depicted in FIG. 9 has a network interface 101, a modulator 102, a D/A converter 103, a transmitter 104, a splitter 106, a receiver 107, an A/D converter 108, a demodulator 109, and a control device 110. The transmitter 104 includes a power amplification unit 105, and the power amplification unit 105 may correspond to the power amplification device 10.

Transmission data is modulated by the modulator 102, subjected to D/A conversion by the D/A converter 103, and subjected to transmission processing (up-conversion, amplification, or the like) by the transmitter 104, and is thereby transmitted as a wireless signal via the splitter 106 and an antenna.

A wireless signal which is received via the antenna and the splitter 106 is subjected to reception processing (down-conversion or the like) by the receiver 107, subjected to A/D conversion by the A/D converter 108, demodulated by the demodulator 109, and serves as reception data.

The control device 110 controls the network interface 101, the modulator 102, the D/A converter 103, the transmitter 104, the receiver 107, the A/D converter 108, and the demodulator 109. The control device 110 includes a central processing unit (CPU) and memory. The memory may include, for example, RAM such as synchronous dynamic random-access memory (SDRAM), read-only memory (ROM), or flash memory.

All examples and conditional language recited herein are intended for pedagogical purposes to aid the reader in understanding the invention and the concepts contributed by the inventor to furthering the art, and are to be construed as being without limitation to such specifically recited examples and conditions, nor does the organization of such examples in the specification relate to a showing of the superiority and inferiority of the invention. Although the embodiments of the present invention have been described in detail, it should be understood that the various changes, substitutions, and alterations could be made hereto without departing from the spirit and scope of the invention.

## Claims

1. A power amplification device, comprising:
an amplifier configured to amplify an input signal;
a switched capacitor, provided at an output stage of the amplifier, configured to change capacitance based on a first control signal;
a matching circuit, provided at the output stage of the amplifier and including a varactor pair in which two varactor diodes are coupled in series and in opposing directions or a varactor pair in which two varactor diodes are coupled in parallel and in opposing directions, configured to change capacitance based on a second control signal;
a detection circuit configured to detect power of the input signal;
a quantization circuit to quantize a detected power value, form a quantized bit string having a high-order bit group and a low-order bit group, and output the high-order bit group as the first control signal to the switched capacitor; and
a conversion circuit to convert the low-order bit group into an analog value and form the second control signal.

2. The power amplification device according to claim 1, wherein the switched capacitor includes a plurality of capacitors that are coupled in parallel and have different capacitance values.

3. The power amplification device according to claim 2, wherein capacitance of a varactor diode included in the varactor pair is equal to or less than the lowest value from among a plurality of capacitance values of the plurality of capacitors.

4. The power amplification device according to any preceding claim,
wherein a connection line for the conversion circuit and the matching circuit is a stripline.

5. The power amplification device according to any preceding claim,
wherein a connection line for the quantization circuit and the switched capacitor is a stripline.
